# EUROPÄISCHE PATENTANMELDUNG

(11) **EP 0 924 974 A1**
(43) Veröffentlichungstag der Anmeldung: **23.06.1999**
(21) Anmeldenummer: 98122998.2
(22) Anmeldetag: 03.12.1998
(51) Int. Cl.: H05K 9/00, H01J 29/86

(54) **Abschirmgehäuse**

(30) Priorität: 20.12.1997 DE 19757052
(71) Anmelder: Widia GmbH, 45145 Essen (DE)
(72) Erfinder: Wilmesmeier, Heinrich Dr.rer.nat., 45477 Mülheim (DE); Kopania, Jörg, 45198 Gelsenkirchen (DE)
(74) Vertreter: Vomberg, Friedhelm, Dipl.-Phys.

(57) **Zusammenfassung**

Die Erfindung betrifft ein Gehäuse zur seitlichen und hinteren Abschirmung von Monitoren gegen äußere Magnetfelder, bestehend aus mehreren, einen inneren Hohlraum zur Monitor-Aufnahme begrenzenden Metallwänden aus einer weichmagnetischen Legierung.

Erfindungsgemäß besteht das Gehäuse aus mehreren, Gehäusekanten und Gehäuseecken bildenden Profilen und flachen Blechen, die lösbar miteinander verbunden sind.

## Beschreibung

Die Erfindung betrifft ein Gehäuse zur seitlichen und hinteren Abschirmung von Monitoren gegen äußere Magnetfelder, bestehend aus mehreren, einen inneren Hohlraum zur Monitor-Aufnahme begrenzenden Metallwänden aus einer weichmagnetischen Legierung.

Magnetische Felder, wie sie z.B. durch große Ströme in industriellen Anlagen, insbesondere Motoren, Generatoren oder Transformatoren, oder auch Dauermagnete erzeugt werden, führen bei nicht abgeschirmten Monitoren zu unerwünschten Bildbeeinflussungen. Bereits geringe niederfrequente Feldstärken/Flußdichten führen zu Farbverfälschungen, Schriftveränderungen, einem Kippen und/oder Zittern des Bildes, die ein Arbeiten an dem Monitor-Bild zumindest erschweren. Dies geht so weit, daß zum Teil nicht einmal mehr die Mindestvorschriften zur Sicherheit und dem Gesundheitsschutz an Arbeitsplätzen nach der erlassenen EG-Richtlinie erfüllt werden.

Es ist daher bereits üblich, diesem Störfaktor durch Magnetfeldabschirmungen zu begegnen. Hierfür bieten sich zwei Lösungen an:

Die Innenabschirmung, bei der Bleche aus weichmagnetischem Material in das Monitor-Gehäuse eingebaut werden oder die Außenabschirmung, bei der der Monitor durch ein Gehäuse ummantelt wird. Nach dem Stand der Technik werden solche Abschirmgehäuse als starre Gehäuse angeboten, die den Nachteil haben, daß das betreffende Gehäuse nur für eine Monitor-Größe angepaßt ist. Adaptionen zu größeren Monitoren oder volumetrische Anpassungen an kleinere Monitore sind nicht möglich.

Die betreffenden Gehäuse sind im wesentlichen den Monitor-Außenmaßen angepaßt und an der Vorderseite offen. Dies führt zum Teil dazu, daß schrägwinklig auftreffende Magnetfeldlinien noch erhebliche Bild-Störungen verursachen können.

Nach einer weiteren Ausführungsform des Standes der Technik sind daher Gehäuse mit einem vorderseitig aufsetzbaren bzw. ausfahrbaren Tubus vorgeschlagen worden. Hierbei handelt es sich um hohlraumförmige Aufsätze, die entweder aufgesteckt oder ausgezogen werden können, um den Abschirmeffekt zu verstärken. Abgesehen von der variablen Gehäusegestaltung über den aufsetzbaren oder ausschiebbaren Tubus ist jedoch auch dieses Gehäuse, weil lediglich für eine einzige Monitorgröße passend, nicht adaptionsfähig. Ein Austausch eines Monitors gegen einen solchen mit anderen Ausmaßen, z.B. ein Wechsel von einem 14 Zoll- zu einem 17 Zoll-Monitor, bedingt daher, daß auch das Abschirmgehäuse ausgetauscht werden muß. Dies gilt sogar für kleinere bauliche Veränderungen im hinteren Bereich des Monitors der die Elektronenstrahlröhre umhüllt.

Weiterhin besitzen die angebotenen Abschirmgehäuse einen konstanten Abschirmfaktor. Erweist sich dieser Faktor als zu gering, läßt sich im Regelfall ein Gehäuseaustausch ebenfalls nicht vermeiden.

Es ist daher Aufgabe der vorliegenden Erfindung, ein Abschirmgehäuse der eingangs genannten Art zu schaffen, das hinsichtlich der Größe der aufzunehmenden Monitore und/oder des Abschirmfaktors Variationsmöglichkeiten eröffnet.

Diese Aufgabe wird durch das im Anspruch 1 beschriebene Gehäuse gelöst, das dadurch gekennzeichnet ist, daß mehrere, Gehäusekanten und Gehäuseecken bildende Profile und flache Bleche lösbar miteinander zu einem Hohlkörper verbunden sind. Dies lösbaren Verbindungen machen es möglich, einzelne Teile des Gehäuses auszutauschen oder hinsichtlich des relativen Abstandes zu benachbarten Teilen distanzierter oder näher aneinander anzuordnen, so daß Gehäusevariationen der Größe ebenso möglich sind wie der Austausch einzelner Bleche bzw. Eckprofile, um gewünschten höheren Abschirmungen Genüge zu tun.

Weiterbildungen der Erfindung sind in den Unteransprüchen beschrieben.

Vorzugsweise besteht die lösbare Verbindung aus einer Steck-, Rast- oder Schraubverbindung, um die Handhabbarkeit zu erleichtern.

Nach einer Weiterbildung der Erfindung besitzt von zwei miteinander verbindbaren Teilen, d.h. Profilen und/oder Blechen, jeweils eines mindestens eine Bohrung und das andere mindestens ein Langloch oder einen Schlitz, jeweils zur Durchführung und Aufnahme einer Schraube. Beispielsweise lassen sich auf diese Art Gehäusekanten- und Ecken-Profile mit Blechen, welche als seitliche Wandung dienen, derart verbinden, daß je nach Durchsteckort der Schraube im Langloch der Abstand zweier benachbarter Ecken- und Kantenprofile variabel eingestellt werden kann, je nach dem, welche Größe der zu umhüllende Monitor hat. Bei solchen Gehäusen ist es nach Lösen der Schrauben auch ohne weiteres möglich, das Gehäuseinnere entsprechend "umzubauen".

Nach einer weiteren bevorzugten Ausführungsform besteht mindestens eine Gehäusewand aus mehreren, parallel aufeinandergelegten oder zueinander beabstandeten Blechen, wobei der Abstand durch Einsatz von Distanzstücken, wie Hülsen oder ähnlichem, erreicht werden kann. Durch zusätzliches Aufmontieren eines oder mehrerer Bleche wird die Gesamtdicke des dann geschaffenen Blechpaketes erhöht, womit ein entsprechend größerer Abschirmfaktor erzielt wird.

Im Rahmen der vorliegenden Erfindung ist es ebenso möglich, die in Richtung der offenen Gehäusevorderseite ragenden Profile und/oder Bleche längsverschiebbar zur Ausbildung eines variablen Tubus anzuordnen. Ggf. sind hier über die vorhandenen Verbindungen entsprechende Tubus-Profile aufsetzbar oder auch nach Art eines Nut-Feder-Prinzipes aufsteckbar. Insbesondere können die stirnseitig an der offenen Gehäusevorderseite endenden Profile und/oder Bleche abgekantet sein, wobei die abgekanteten Profil- oder Blechteile schrägwinklig zur Bildschirmseite eines in das Gehäuse eingesetzten Monitors angeordnet sind. Die Länge der freien Enden der Profile oder Bleche sowie deren schrägwinklige Anordnung oder auch die wirksame Tubus-Tiefe richtet sich nach der Stärke und dem Einfallswinkel der störenden elektromagnetischen Felder.

Die Profile und/oder Bleche bestehen vorzugsweise aus Eisen oder einer Nickel-Eisen-Legierung, die der IEC-404-1-Normung A, E1 oder E3 entspricht. Betreffende Normung der Magnetmaterialien sind in der genannten Publikation 404-1 aus dem Jahr 1979 von der Internationalen Elektrotechnischen Kommission aufgestellt worden. Verwendbare Werkstoffe aus Reineisen oder weichmagnetischem Eisen haben folgende Zusammensetzung: 0,005 bis 0,03 Massen-% C, 0,002 bis 0,01 Massen-% Si, 0,03 bis 0,2 Massen-% Mn, 0,005 bis 0,015 Massen-% P, 0,01 bis 0,03 Massen-% S, 0,002 bis 0,08 Massen-% Al, 0,002 bis 0,1 Massen-% Ti, Rest Eisen. Die magnetische Flußdichte in Abhängigkeit der Feldstärke sollte folgende Werte besitzen: Bei einer Feldstärke von 5 kA/m eine Flußdichte zwischen 1,45 T bis 1,65 T und bei einer Feldstärke von 15 kA/m eine Flußdichte zwischen 1,75 T bis 1,82 T. Weichmagnetische Legierungen E1-Typus besitzen 72 bis 83 Massen-% Nickel, kleineren Mengen von Legierungselementen wie Molybdän, Kupfer, Chrom oder Silicium, etwa in der vorgenannten Größenordnung, Rest Eisen. Die Anfangspermeabilität liegt zwischen 30000 und 120000.

Legierungen vom E3-Typ haben Nickelgehalte zwischen 45 bis 50 Massen-%, Rest Eisen, wozu geringe Mengen von Legierungselementen wie Molybdän, Kupfer, Chrom oder Silicium (neben unvermeidbaren Verunreinigungen) kommen können. Die maximalen Permeabilitäten liegen zwischen 30000 und 120000. Die Sättigungsflußdichte beträgt 1,5 T bis 1,6 T und die Koerzivität 2 A/m bis 12 A/m.

Alle Stoffe können durch Kaltwalzen, etwaiges Biegen, Bohren oder sonstige mechanische Bearbeitung vorbehandelt werden, bevor sie einer Schlußglühung bei mindestens 1000°C unterzogen werden.

Bevorzugt liegt der Gehäuseabschirmfaktor mindestens bei 20 bis 50, sofern einlagige Profile oder Bleche, insbesondere einer Dicke zwischen 0,2 mm bis 2 mm verwendet werden. Bei mehrlagigen Profilen oder Blechen kann der Abschirmfaktor auf 100 bis 300 gesteigert werden.

Ein Ausführungsbeispiel der vorliegenden Erfindung ist in den Zeichnungen dargestellt. Es zeigen
- Fig. 1: eine Prinzipskizze eines erfindungsgemäßen Gehäuses,

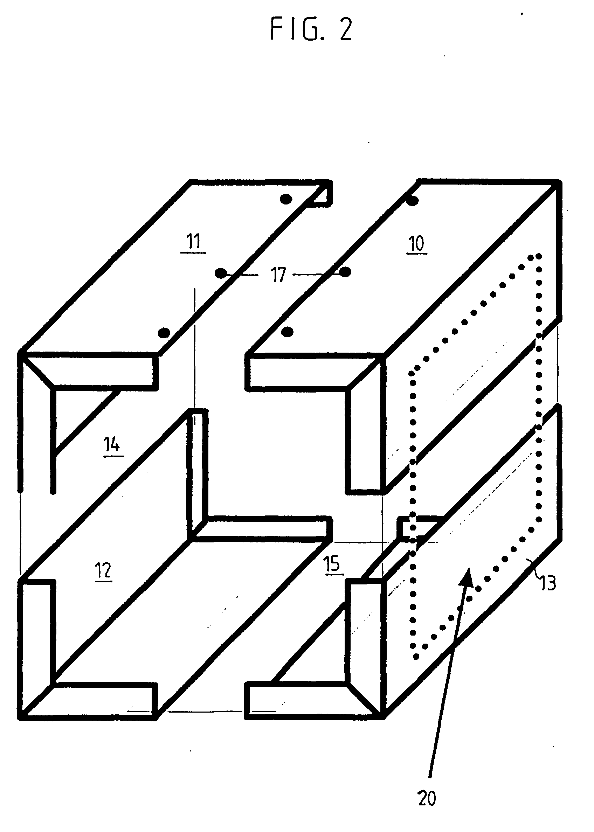

- Fig. 2: eine Prinzipskizze desselben Gehäuses mit einem zusätzlich montierten Abschirmblech,
- Fig. 3: eine Detailansicht eines Kanten-Profiles und
- Fig. 4: eine Detailansicht eines Wand-Bleches, hier als Dach-Blech.

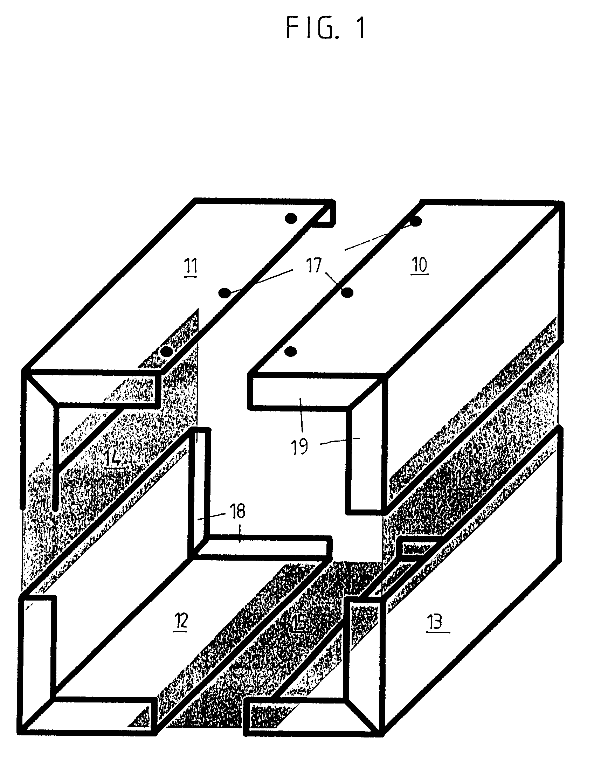

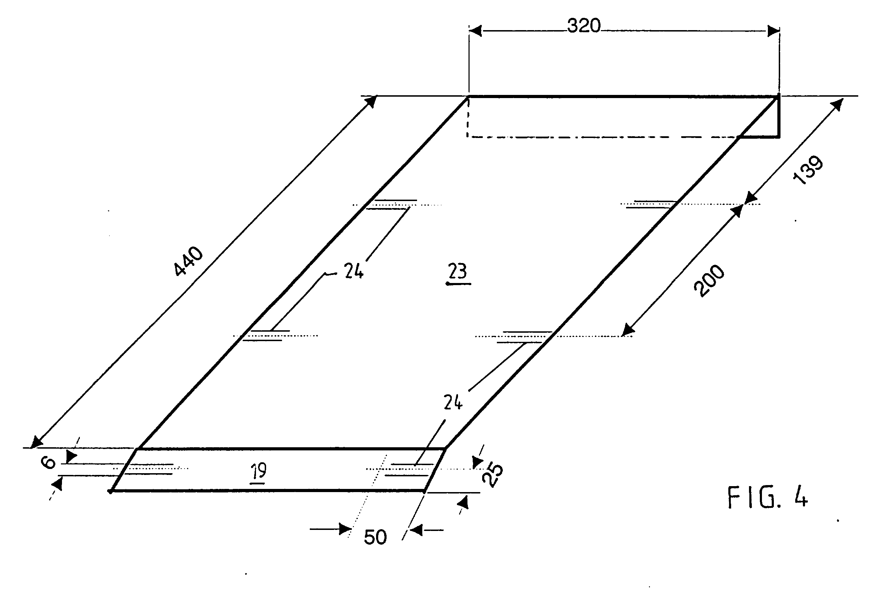

Ein Abschirmgehäuse nach der vorliegenden Erfindung besteht aus einer, hier nicht dargestellten, aber der Elektronenstrahlröhre formangepaßten oder planen Rückwand, einem Dach-Blech, einem Bodenblech
sowie zwei Seitenblechen. Anstelle der nach dem Stand der Technik durch die genannten Teile starren Gehäuseausbildung ist im Rahmen der vorliegenden Erfindung eine größenvariable, modular zusammengesetzte Ausführungsform gewählt, bei der jeweils vorgefertigte Gehäuse-Eckenprofile 10 bis 13 mittels Verbindungsblechen 14, 15 und 16 zur Ausbildung eines ringsum geschlossenen Gehäusekörpers verbunden werden. Das die beiden Eckenprofile 10 und 11 verbindende Dachblech ist aus Gründen der Übersichtlichkeit weggelassen worden. Die Eckenprofile besitzen vorgefertigte Bohrungen 17, die mit entsprechenden Langlöchern in den Blechen 14, 15 und 16 zur Deckung gebracht werden, wonach über eine Mutter-Schraubenverbindung jeweils zwei Gehäuseeckenprofile mit einem Blech verbunden werden. Zur Verbesserung der Abschirmung können, falls angebracht, auch weichmagnetische Schrauben und Muttern aus genannten Legierungen verwendet werden. Im vorliegenden Beispiel werden die Eckenprofile 11 und 12 mit dem Blech 14, die Eckenprofile 12 und 13 mit dem Blech 15 und die Eckenprofile 10 und 13 mit dem Blech 16 miteinander verbunden. Der Abstand zweier benachbarter Eckenprofile kann im Rahmen der Länge einer durch entsprechende Schlitze oder Langloch-Durchbrechungen vorgegebenen Toleranz gewählt werden. Neben einer Schraubverbindung können auch andere Verbindungsmittel verwendet werden, z.B. in Form von Bajonett-Schraubverschlüssen, federnden Rastzungen, die vorgesehene Hinterschneidungen hinterfassen, oder auch Steckverbindungen, z.B. dergestalt, daß die Eckprofile 10, 11, 12 oder 13 außen oder innen Nuten bildende Leisten aufweisen, in die Bleche 14, 15 oder 16 eingesteckt werden können. In einem solchen Fall wird durch Wahl der Blechhöhe oder Blechbreite das Endmaß des Gehäuses bestimmt. An der Vorder- und an der Rückseite der Eckenprofile sowie der Bleche sind umgebogene Streifen 18 vorgesehen, an denen rückseitig ein hinteres Abschirmblech befestigt werden kann. Die an der Vorderseite des Gehäuses vorhandenen Blechstreifen 19 können entweder rechtwinklig zu den jeweiligen Dach-, Boden- oder Seitenflächen des Gehäuses stehen oder schrägwinklig, wie dies insbesondere anhand der Fig. 4 zu erkennen ist. Das in Fig. 1 dargestellte Gehäuse kann zusätzlich noch ein (äußeres) Abschirmblech 20 als Abdeckung aufweisen, das an der Seitenwand außen oder innen angeschraubt ist.

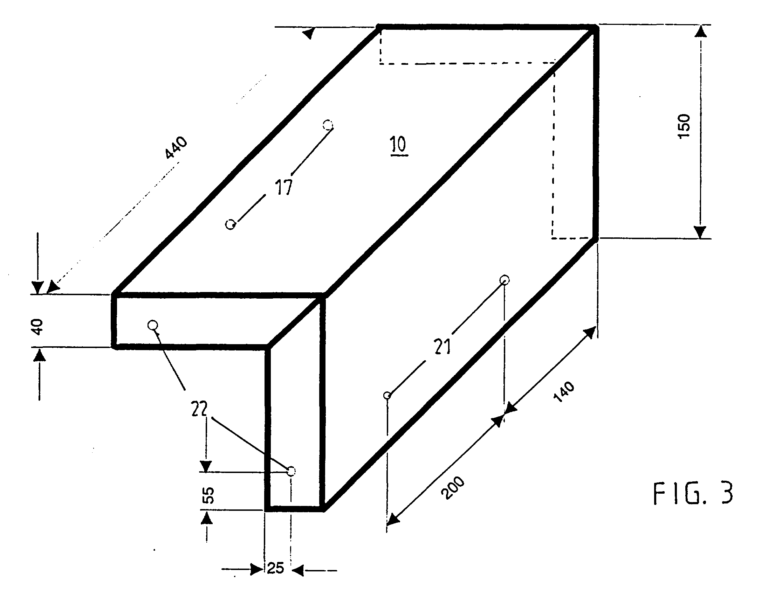

Fig. 3 zeigt eine Detailskizze eines Eckenprofiles 10 als Teil eines Abschirmgehäuses für Monitore der Größe 14 Zoll bis 17 Zoll mit betreffenden Maßen bzw. Abstandsmaßen für die Bohrungen 17, 21 und 22. Das zugehörige, in Fig. 4 dargestellte Blech 23 läßt sich sowohl als Seitenblech 14 oder 16 als auch als Dach- bzw. Bodenblech 15 verwenden. Die Blechlänge sowie der Neigungswinkel der abgekanteten Lasche 19 entsprechen den durch die Maße des Eckenprofiles 10 vorgegebenen Größen. Jeweils von der Seite her sind mit einer Tiefe von 50 mm Schlitze 24 vorgesehen, wodurch sich die Breite wie die Höhe des Abschirmgehäuses zwischen ca. 45 cm und 55 cm (Innenmaß) variieren lassen können. Je nach Überlappungsgrad der Randbereiche der Bleche 23 mit den Eckprofilen 10 bis 12 erhält man ein größeres oder kleineres Abschirmgehäuse. Eine Überlappung der Bleche kann auch dazu ausgenutzt werden, um den Abschirmeffekt zu verstärken. In entsprechender Weise können durch breitere Bleche z.B. Abschirmgehäusevarianten für 21 Zoll oder 23 Zoll abgedeckt werden.

## Patentansprüche

1. Gehäuse zur seitlichen Abschirmung von Monitoren gegen äußere Magnetfelder, bestehend aus mehreren, einen inneren Hohlraum zur Monitor-Aufnahme begrenzenden Metallwänden aus einer weichmagnetischen Legierung,
**dadurch gekennzeichnet,**
daß das Gehäuse aus mehreren, Gehäusekanten und Gehäuseecken bildenden Profilen (10 bis 13) und flachen Blechen (14 bis 26, 23) besteht, die lösbar miteinander verbunden sind.

2. Gehäuse nach Anspruch 1, dadurch gekennzeichnet, daß die lösbare Verbindung aus einer Steck-, Rast- oder Schraubverbindung besteht.

3. Gehäuse nach Anspruch 2, dadurch gekennzeichnet, daß von zwei miteinander verbindbaren Teilen (Profilen, Blechen) jeweils eines mindestens eine Bohrung (17, 21, 22) und das andere mindestens ein Langloch oder einen Schlitz (24), jeweils zur Durchführung und Aufnahme einer Schraube, besitzt.

4. Gehäuse nach einem der Ansprüche 1 bis 3, dadurch gekennzeichnet, daß mindestens eine Gehäusewand aus mehreren, parallel aufeinandergelegten oder zueinander beabstandeten Blechen (16, 20) besteht.

5. Gehäuse nach einem der Ansprüche 1 bis 4, dadurch gekennzeichnet, daß die in Richtung der offenen Gehäusevorderseite ragenden Profile und/oder Bleche längsverschiebbar zur Ausbildung eines variablen Tubus angeordnet sind.

6. Gehäuse nach einem der Ansprüche 1 bis 5, dadurch gekennzeichnet, daß die stirnseitig an der offenen Gehäusevorderseite endenden Profile und/oder Bleche abgekantet sind, wobei die abgekanteten Profil- oder Blechteile (19) schrägwinklig zur Bildschirmseite eines in das Gehäuse eingesetzten Monitors angeordnet sind.

7. Gehäuse nach einem der Ansprüche 1 bis 6, dadurch gekennzeichnet, daß die Profile und/oder Bleche aus Fe oder einer Ni-Fe-Legierung der IEC-404-1-Normung A, E1 oder E3 bestehen.

8. Gehäuse nach Anspruch 7, dadurch gekennzeichnet, daß die Profile und/oder Bleche nach der mechanischen Bearbeitung durch Biegen, Bohren, Fräsen oder ähnlichem einer Schlußglühung bei ≥1000°C, vorzugsweise unter einer H₂-Atmosphäre unterzogen worden sind.

9. Gehäuse nach einem der Ansprüche 1 bis 8, dadurch gekennzeichnet, daß der Gehäuseabschirmfaktor mindestens 20 bis 50 bei Verwendung einlagiger Profile oder Bleche und 100 bis 300 bei Verwendung mehrlagiger Profile oder Bleche beträgt.

10. Gehäuse nach einem der Ansprüche 1 bis 9, dadurch gekennzeichnet, daß die Profile und/oder Bleche eine Dicke zwischen 0,2 mm bis 2 mm, vorzugsweise von 1 mm, besitzen.
